# EUROPÄISCHE PATENTSCHRIFT

(11) **EP 0 402 490 B1**
(45) Veröffentlichungstag und Bekanntmachung des Hinweises auf die Patenterteilung: **19.05.1993**
(21) Anmeldenummer: 89110553.8
(22) Anmeldetag: 10.06.1989
(51) Int. Cl.: G01R 1/067

(54) **Messspitzen-Manipulator für Wafermessgeräte**
Measuring-probe manipulator for a wafer-testing device
Manipulateur de sonde de mesure pour appareil de test de plaquette de circuit

(43) Veröffentlichungstag der Anmeldung: 19.12.1990
(73) Patentinhaber: Deutsche ITT Industries GmbH, 79108 Freiburg (DE)
(72) Erfinder: Schmidt, Hans, D-7841 Auggen (DE); Günter, Helmut, D-7800 Freiburg-Munzingen (DE)

(56) Entgegenhaltungen:
- US-A- 3 333 274
- US-A- 3 648 169
- US-A- 4 746 857
- IBM TECHNICAL DISCLOSURE BULLETIN, Band 20, Nr. 9, Februar 1978, Seiten 3461-3462; L.H. FAURE et al.: "Testing apparatus with selectable probes and contactors for use with changable patterns"
- IBM TECHNICAL DISCLOSURE BULLETIN, Band 13, Nr. 7, Dezember 1970, Seiten 2113-2114; J.W. WAGNER et al.: "Orbiting Probe"

## Beschreibung

Die Erfindung betrifft einen Meßspitzen-Manipulator für Wafermeßgeräte mit den Merkmalen des Anspruchs 1.

In der Halbleitertechnik bedient man sich zur Bestimmung der Parameter der auf einem Wafer ausgebildeteten Bauelemente sogenannter Prüfnadeln, die jeweils über einen entsprechenden Halter mit einem Manipulator verbunden sind, der mit Hilfe von in den Achslagen X, Y und Z an verschiedenen Seiten des Manipulators sitzenden Stellspindeln auf die Meßpunkte aufgesetzt wird.

Bei den auf dem Markt befindlichen Geräten sind vielfach die einzelnen Achsen konstruktionsbedingt nicht völlig unabhängig voneinander, wird z.B. die entsprechende Stellspindel in Richtung der X-Achse verstellt, so bewegt sich die Meßspitze auch im u-Bereich in der Y-bzw. Z-Achse. Außerdem beschreibt die Meßspitze bei vielen Geräten bei der Verstellung einen Bogen, was bei den heute üblichen sehr kleinen Strukturen einen erheblichen Nachteil bedeutet. Darüber hinaus ergibt sich durch die Anordnung der Stellspindeln an drei verschiedenen Seiten des Meßgerätes ein erhöhter Platzbedarf und eine Beeinträchtigung in der Bedienung, wenn mehrere Manipulatoren nebeneinander angeordnet sind.

Aus der Druckschrift US-A-3 333 274 ist ein Meßspitzen-Manipulator für Wafermeßgeräte bekannt, bei dem die drei Stellspindel in Richtung einer Achse parallel fluchtend an der einen Schmalseite des Aufbaus angeordnet sind.

Die Erfindung, wie sie in den Ansprüchen gekennzeichnet ist, löst die Aufgabe, einen Meßspitzen-Manipulator anzugeben, der gegenüber den Bekannten einen geringeren Raumbedarf zeigt und eine einfachere Bedienung bei verbesserter Genauigkeit ermöglicht.

Die Erfindung wird nun anhand der Figuren der Zeichnung eines Ausführungsbeispiels näher erläutert.
Fig.1 zeigt die Seitenansicht des erfindungsgemäßen Meßspitzen-Manipulators teilweise geöffnet bzw. im Schnitt,
Fig.2 zeigt den Schnitt längs der Linie A-A′ in Fig.1, und
Fig.3 zeigt die Vorderansicht der einen Schmalseite des Meßspitzen-Manipulators mit dem Aufnehmer für den Meßspitzenhalter.

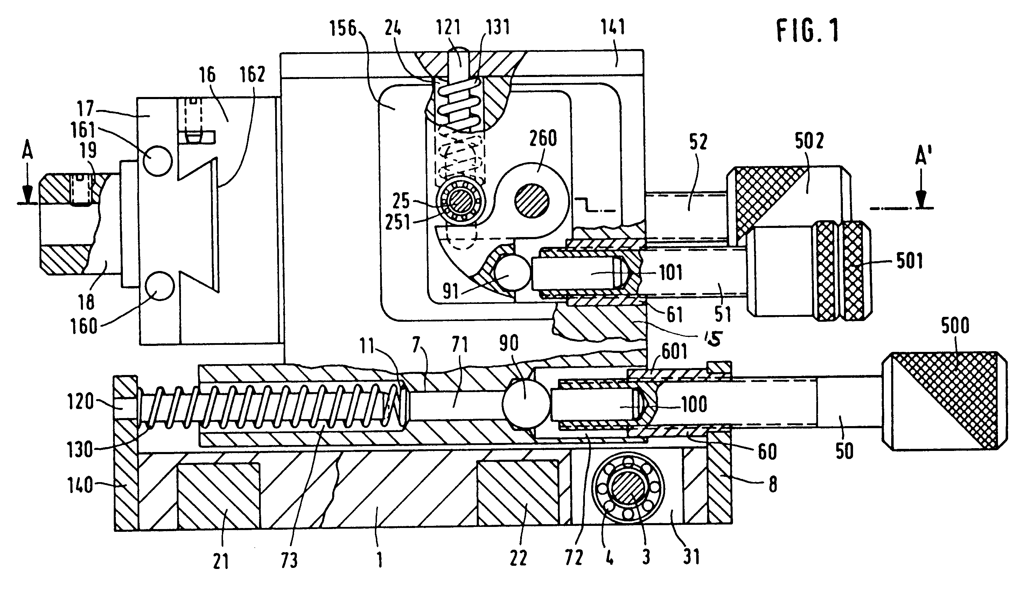

Die Seitenansicht nach Fig.1 wird teilweise im Schnitt, sowie geöffnet gezeigt. Auf der Unterseite eines Basisteils 1 sind zum Befestigen des Gerätes auf einer Unterlage, z.B. einer Meßplattform, mindestens zwei Haftmagnete 21, 22 bündig eingelassen. Zum Lösen dient die mit zwei Kugellagern 4 und dem Abdrückhebel 27 versehene Exzenterwelle 3, die im Hohlraum 31 des Basisteils 1 untergebracht ist. An der einen Schmalseite desselben ist die Mutterplatine 8 befestigt, in der einseitig die Spindelmutter 60 fixiert ist, deren freies Ende 601 in das gegen sie gerichtete erweiterte Ende 72 einer Bohrung 7 im Kreuzschieber 15 hineinragt, der über eine einstellbare Schwalbenschwanzführung mit dem Basisteil 1 verbunden ist. In der Spindelmutter 60 befindet sich die erste Stellspindel 50, sie trägt am Drehknopf 500 abgewandten Ende den gehärteten Druckbolzen 100, der an der Kontaktkugel 90 anliegt, die am verengten Mittelteil 71 der Bohrung 7 fixiert ist. An der anderen Schmalseite des Basisteils 1 ist eine Federplatine 140 befestigt, in der das eine Ende des Federführungsbolzens 120 fixiert ist, der in den zweiten, auf die Federplatine 140 hin gerichteten erweiterten Endteil 73 der Bohrung 7 hineinragt. Auf dem Federführungsbolzen ist die Druckfeder 130 aufgesteckt, die sich zwischen der Federplatine 140 einerseits und der Federanlage 11 am Übergang vom verengten Mittelteil 71 zum Endteil 73 erstreckt. Der Durchmesser des Mittelteils 71 ist geringfügig größer als der des Federführungsbolzens 120, so daß beim Drehen der Stellspindel 50 der Federführungsbolzen 120 in das Mittelteil 71 hinein- oder herausgleiten kann, wenn der Kreuzschieber 15 beim Betrieb des Manipulators auf der X-Achse vor- oder rückwärts bewegt wird.

In einer zweiten, in dem Kreuzschieber 15 eingesetzten Spindelmutter 61 ist die zweite Stellspindel 51 eingeschraubt, die wiederum an ihrem vom Drehkopf 501 abgewandten Vorderende mit einem gehärteten Druckbolzen 101 versehen ist. Beim Drehen der Stellspindel 51 im Uhrzeigersinn drückt diese auf eine Kontaktkugel 91, die an einem an der Abdeckplatine 156 drehbar gelagerten Schwenkhebel 260 fixiert ist. Dieser steht im Eingriff mit dem Kugellager 251, das auf einen Mitnehmerbolzen 25 aufgesteckt ist, der an dem Vertikalschieber 16 befestigt, in einer Nut 24 des Kreuzschiebers 15 verschiebbar und von einer Druckfeder 131 beaufschlagt ist, die auf den in der Federplatine 141 befestigten Federführungsbolzen 121 aufgesteckt ist und sich an der Federplatine 141 abstützt.

Durch das beschriebene Zusammenwirken der Teile wird der Vertikalschieber 16 gegen den Federdruck nach oben verschoben. Beim Drehen der Stellspindel 51 entgegen dem Uhrzeigersinn drückt die Druckfeder 131 den Vertikalschieber 16 nach unten.

Der Vertikalschieber 16 ist über eine erste einstellbare Schwalbenschwanzführung verschiebbar mit dem Kreuzschieber 15 verbunden ist und trägt, in einer einstellbaren zweiten Schwalbenschwanzführung 162 verschiebbar, den Querschieber 17, an dessen Vorderseite der Aufnehmer 18 für den Meßspitzenhalter befestigt ist, wobei z.B. die Fixierung des letzteren über eine in die Gewindebohrung 19 eingeschraubte Schraube erfolgt. Die an der Breitseite des Vertikalschiebers 16 angebrachte Federplatine 142 ist abgenommen, so daß man sowohl die einstellbare Schwalbenschwanzführung 162 im Vertikalschieber 16 wie auch die Bohrungen 160, 161 im Querschieber 17 sieht.

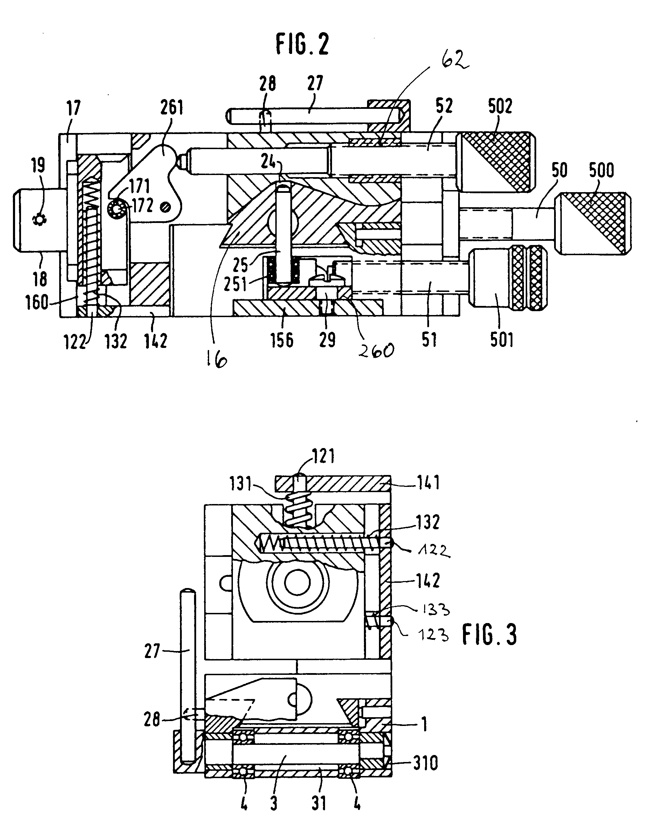

Die Fig.2 zeigt den Schnitt entlang der Linie A-A' in Fig.1. Es ist der an der Exzenterwelle 3 angebrachte Abdrückhebel 27 zu erkennen, der an dem Anschlagstift 28 anliegt und zum Lösen des Manipulators von der Meßplattform dient. Der Querschnitt verdeutlicht ferner nochmals die Lage der Stellspindeln 50, 51 und 52 zueinander. Man sieht außerdem, wie der Schwenkhebel 260 über die Lagerschraube 29 an der Abdeckplatine 156 drehbar befestigt ist. Der einseitig im Vertikalschieber 16 fixierte Mitnehmerbolzen 25, der auf das Kugellager 251 aufgesteckt ist, ist in der Nut 24 verschiebbar.

Fig.2 läßt ferner die dritte Stellspindel 52 mit dem Drehknopf 502 erkennen, die über die Spindelmutter 62 auf den zweiten Umlenkhebel 261 einwirkt, der drehbar am Vertikalschieber 16 angebracht ist. Der Umlenkhebel 261 greift an einem Kugellager 171 an, welches in einer Nut des Querschiebers 17 mittels eines Zylinderstiftes 172 befestigt ist.

Drehen der Stellspindel 52 im Uhrzeigersinn bewirkt eine Verschiebung des Querschiebers 17 entgegen der Federkraft nach links. Beim Drehen der Stellspindel 52 entgegen dem Uhrzeigersinn drücken die Federn 132 den Querschieber 17 nach rechts.

Wie in Verbindung mit Fig.1 erwähnt, enthält der Querschieber 17 zwei Bohrungen 160 und 161, in denen jeweils eine Druckfeder 132, 133 untergebracht ist. Diese stützen sich einmal gegen das Bohrungsende und zum andern gegen die Federplatine 142 ab. An der Federplatine 142 ist ferner jeweils ein Federführungsbolzen einseitig fixiert, wobei in Fig.2 lediglich die Druckfeder 132 und der Federführungsbolzen 122 zu sehen sind. An dem Querschieber 17 befindet sich der Aufnehmer 18 mit der Gewindebohrung 19 für eine Klemmschraube zum Feststellen des Meßspitzenhalters.

Die Fig.3 verdeutlicht den Blick auf die linke Schmalseite der in Fig.1 dargestellten Ausführungsform der Erfindung, man sieht wieder den Aufnehmer 18 für den Meßspitzenhalter sowie ferner den Abdrückhebel 27, mit dessen Hilfe das Gerät bei Bedarf von der Meßplattform getrennt werden kann. Der Abdrückhebel 27 ist an der Exzenterwelle 3 befestigt, die über die Kugellager 4 beim Lösen auf die Unterlage drückt. Die Exzenterwelle 3 ist vom Abdrückhebel abseitigen Ende über eine Klemmscheibe 310 am Basisteil 1 fixiert.

Fig.3 läßt ferner die beiden Bohrungen 160, 161 erkennen, in denen die Federführungsbolzen 122, 123 sowie die Federn 132, 133 untergebracht sind.

Fig.3 macht noch einmal deutlich, wie der Federführungsbolzen 121 und die Feder 131 an der Federplatine 141 befestigt ist.

Beim beschriebenen Ausführungsbeispiel erfolgt die Befestigung des Manipulators auf einer Grundfläche durch zwei bzw. drei Magnete , eine Befestigung mittels Vakuum ist ebenfalls möglich. Hierzu wären im Basisteil Bohrungen anzubringen, die mit einer Zentralbohrung verbunden sind, an der dann auf bekannte Weise ein Vakuum angelegt werden kann. Über ein geeignetes Ventil läßt sich das Vakuum auf Druckluft umschalten, so daß der Manipulator auf der Unterlage schwimmt und leicht wieder abgehoben werden kann.

Die Stellspindeln (50, 51, 52) des Meßspitzen-Manipulators Können manuell oder motorisch betrieben werden.

Die Vorteile der Erfindung liegen einmal in der Lösung der Aufgabe selbst, nämlich einen Meßspitzen-Manipulator zu realisieren, der einen geringen Raum bedarf sowie leichte Bedienbarkeit bei Anbringung der Stellspindeln auf einer Schmalseite aufweist sowie ferner darin, daß alle drei Achsen lineare Bewegungen unabhängig voneinander ausführen. Darüber hinaus ist die Einstellgenauigkeit gegenüber den herkömmlichen Geräten verbessert und ein leichtes Aufsetzen und Entfernen von der Meßplattform gewährleistet.

## Patentansprüche

1. Meßspitzen-Manipulator für Wafermeßgeräte mit den folgenden Merkmalen:
- auf einem Basisteil (1) ist ein in Richtung der X-Achse verschiebbarer Kreuzschieber (15) angebracht, der mit einem Vertikalschieber (16) beweglich verbunden ist, der wiederum einen Querschieber (17) trägt, an dem ein Aufnehmer (18) für Meßspitzenhalter befestigt ist,
- erste, zweite und dritte Stellspindeln (50, 51, 52)sind in Richtung der X-Achse parallel fluchtend an der einen Schmalseite des Aufbaus angeordnet,
- die erste Stellspindel (50) ist in einer an einer Mutterplatine (8) befestigten Spindelmutter (60) aufgenommen, die in das eine Endteil (72) einer Bohrung (7) in dem Kreuzschieber (15) hineinragt, wobei die Bohrung (7) in ihrem Mittelteil (71) eine geringere lichte Weite gegenüber den beiden Endteilen (72, 73) zeigt und die erste Stellspindel (50) über einen Druckbolzen (100) auf eine Kontaktkugel (90) einwirkt, die am zum Druckbolzen (100) hin gerichteten Bohrungsende des Mittelteils (71) angebracht ist, während ein einseitig an einer am Basisteil (1) fixierten ersten Federplatine (140) befestigter erster Federführungsbolzen (120) sich in die Bohrung (7) hinein erstreckt und eine Druckfeder (130) trägt, die sowohl an der ersten Federplatine (140) als auch an der durch die Vergrößerung der lichten Weite der Bohrung (7) zur ersten Federplatine (140) hin gebildeten Federanlage (11) anliegt,
- die zweite Stellspindel (51) ist in einer in dem Kreuzschieber (15) eingelassenen Spindelmutter (61) aufgenommen und wirkt über einen zweiten Druckbolzen (101) auf eine Kontaktkugel (91), die an einem ersten Umlenkhebel (260) befestigt ist, der drehbar an einer Abdeckplatine (156) befestigt ist und über ein Kugellager (251) auf einen Mitnehmerbolzen (25) wirkt, der an dem Vertikalschieber (16) befestigt und in einer Nut (24) des Kreuzschiebers (15) verschiebbar ist, wobei eine auf einen zweiten Federführungsbolzen (121) aufgeschobene Druckfeder (131) sich gegen eine zweite Federplatine (141) einerseits und den Mitnehmerbolzen (25) andererseits abstützt,
- die dritte Stellspindel (52) ist in ihrer Spindelmutter (62) im Vertikalschieber (16) aufgenommen und wirkt auf einen zweiten Umlenkhebel (261) ein, der drehbar gelagert an einem zweiten Kugellager (171) angreift, das mittels eines Zylinderstiftes (172) in einer Nut des Querschiebers (17) befestigt ist, wobei der Querschieber (17) zwei in Richtung der Z-Achse übereinander im Abstand angebrachte Bohrungen (160, 161) mit darin gelagerten Druckfedern (132, 133) aufweist, die jeweils um einen Federführungsbolzen (122, 123) angeordnet sind, die einseitig an einer am Vertikalschieber (16) befestigten Federplatine (142) fixiert sind.

2. Meßspitzen-Manipulator nach Anspruch 1, dadurch gekennzeichnet, daß das Basisteil (1) mindestens zwei Haftmagnete (21, 22) sowie eine mittels zweier Kugellager (4) drehbar gelagerte Exzenterwelle (3) enthält.

3. Meßspitzen-Manipulator nach Anspruch 1 oder 2, dadurch gekennzeichnet, daß die Stellspindeln (50, 51, 52) manuell oder motorisch betrieben werden können.

4. Meßspitzen-Manipulator nach einem der Ansprüche 1 bis 3, dadurch gekennzeichnet, daß der Kreuzschieber (15), der Vertikalschieber (16) und der Querschieber (17) über Schwalbenschwanzführungen verbunden sind.

5. Meßspitzen-Manipulator nach Anspruch 1, 3 oder 4, dadurch gekennzeichnet, daß die Befestigung des Meßspitzen-Manipulators an der Meßplattform mittels Vakuum erfolgt.

## Claims

1. Test-probe manipulator for wafer-probing apparatus having the following features:
- A base (1) has a compound rest (15) attached thereto which is movable in the direction of the X-axis and is movably connected with a vertical slide (16) supporting a cross slide (17) to which a receptacle (18) for testprobe holders is attached;
- first, second, and third adjusting spindles (50, 51, 52) are arranged at one narrow side of the manipulator and extend parallel to each other in the direction of the X-axis;
- the first adjusting spindle (50) is received in a spindle nut (60) attached to an nut holder (8) and extending into one end portion (72) of a hole (7) in the compound rest (15), the diameter of the center portion (71) of the hole (7) being less than that of the two end portions (72, 73), and the first adjusting spindle (50) acting via a thrust bolt (100) on a contact ball (90) which is fixed at the end of the central portion (71) of the hole (7) directed toward the thrust bolt (100), while a first spring-guiding pin (120) mounted at one end in a first pin holder (140) attached to the base (1) extends into the hole (7) and supports a compression spring (130) which rests both against the first pin holder (140) and against the spring-bearing surface (11) formed by the enlargement of the diameter of the hole (7) toward the first pin holder (140);
- the second adjusting spindle (51) is received in a spindle nut (61) fitted in the compound rest (15) and acts via second thrust bolt (101) on a contact ball (91) fixed at a first follower (260) which is pivoted to a cover plate (156) and acts via a ball bearing (251) on a driving pin (25) which is attached to the vertical slide (16) and is movable in a groove (24) of the compound rest (15), with a compression spring (131) on a second spring-guiding pin (121) resting against a second pin holder (141) on the one hand and against the driving pin (25) on the other, and
- the third adjusting spindle (52) is received in its spindle nut (62) in the vertical slide (16) and acts on a second follower (261) which is pivoted attached on a second ball bearing (171) fixed in a groove of the cross slide (17) by means of a straight pin (172), the cross slide (17) having two spaced apart holes (160, 161) arranged one above the other in the direction of the Z-axis and each containing a compression spring (132, 133) disposed around a spring-guiding pin (122, 123) which has one end fixed in a third pin holder (142) attached to the vertical slide (16).

2. A test-probe manipulator as claimed in claim 1, characterized in that the base (1) contains at least two holding magnets (21, 22) and an eccentric shaft (3) rotatably mounted by means of two ball bearings (4).

3. A test-probe manipulator as claimed in claim 1 or 2, characterized in that the adjusting spindles (50, 51, 52) can bei operated manually or by means of a motor.

4. A test-probe manipulator as claimed in any one of claims 1 or 3, characterized in that the compound rest (15), the vertical slide (16), and the cross slide (17) are interconnected via dovetail guides.

5. A test-probe manipulator as claimed in claim 1, 3 or 4, characterized in that the attachment of the test-probe manipulator to a test platform is caused by vacuum.

## Revendications

1. Manipulateur de touches de mesure, pour appareil de mesure pour plaquettes, comportant les particularités suivantes :
- un coulisseau à mouvements perpendiculaires (15) est monté sur une partie de base (1), ce coulisseau étant agencé de façon à pouvoir se déplacer selon la direction de l'axe X et étant relié d'une manière mobile à un coulisseau vertical (16) qui porte lui-même un coulisseau transversal (17) sur lequel est fixé un logement (18) pour un porte-touche de mesure,
- une première, une seconde et une troisième tiges filetées de réglage (50, 51, 52) sont montées sur l'une des petites faces de la structure en formant un alignement parallèle selon la direction de l'axe X,
- la première tige filetée de réglage (50) est vissée dans un écrou de tige filetée (60) qui est fixé sur une platine d'écrou (8) et qui pénètre dans l'une (72) des parties extrêmes d'un alésage (7) ménagé dans le coulisseau à mouvements perpendiculaires (15), l'alésage (7) présentant dans sa partie centrale (71) un diamètre plus faible que les deux parties extrêmes (72, 73) et la première tige filetée de réglage (50) agissant, par l'intermédiaire d'une tige de poussée (100), sur une bille de contact (90) qui est montée sur l'extrémité de l'alésage de la partie centrale (71) qui est tournée vers cette tige de poussée (100), tandis qu'une première tige de guidage de ressort (120), fixée d'un côté sur une première platine de ressort (140) fixée sur la partie de base (1), s'étend dans l'alésage (7) et porte un ressort de compression (130) qui prend appui d'une part sur la première platine de ressort (140) et d'autre part sur un appui de ressort (11) constitué par l'élargissement du diamètre de l'alésage (7) réalisé en direction de cette première platine de ressort (140),
- la seconde tige filetée de réglage (51) est vissée dans un écrou de tige filetée (61) ménagé dans le coulisseau à mouvements perpendiculaires (15) et agit, par l'intermédiaire d'une seconde tige de poussée (101), sur une bille de contact (91) qui est fixée sur un premier levier de renvoi (260) qui est monté d'une manière rotative sur une platine de recouvrement (156) et agit, par l'intermédiaire d'un roulement à billes (251), sur une tige d'entraînement (25) qui est fixée sur le coulisseau vertical (16) et est agencée de façon à pouvoir se déplacer dans une rainure (24) du coulisseau à mouvements perpendiculaires (15), un ressort de compression (131), enfilé sur une seconde tige de guidage de ressort (121), prenant appui d'une part contre une seconde platine de ressort (141) et d'autre part contre la tige d'entraînement (25),
- la troisième tige filetée de réglage (52) est vissée dans son écrou de tige filetée (62) monté dans le coulisseau vertical (16) et agit sur un second levier de renvoi (261) qui, en étant monté d'une manière rotative, vient en prise sur un second roulement à billes (171) qui est fixé dans une rainure du coulisseau transversal (17) au moyen d'une tige cylindrique (172), le coulisseau transversal (17) comportant deux alésages (160, 161) qui sont disposés selon la direction de l'axe Z l'un au-dessus de l'autre et à distance l'un de l'autre et dans lesquels sont montés des ressorts de compression (132, 133) qui sont disposés chacun autour d'une tige de guidage de ressort (122, 123), ces tiges de guidage étant fixées d'un côté sur une platine de ressorts (142) fixée sur le coulisseau vertical (16).

2. Manipulateur de touches de mesure suivant la revendication 1, caractérisé en ce que la partie de base (1) comporte au moins deux aimants adhérents (21, 22) et un arbre excentré (3) monté rotatif au moyen de deux roulements à billes (4).

3. Manipulateur de touches de mesure suivant la revendication 1 ou 2, caractérisé en ce que les tiges filetées de réglage (50, 51, 52) peuvent être manoeuvrées à la main ou au moyen d'un moteur.

4. Manipulateur de touches de mesure suivant l'une des revendications 1 à 3, caractérisé en ce que le coulisseau à mouvements perpendiculaires (15), le coulisseau vertical (16) et le coulisseau transversal (17) sont assemblés par l'intermédiaire de glissières en queue d'aronde.

5. Manipulateur de touches de' mesure suivant la revendication 1, 3 ou 4, caractérisé en ce que la fixation du manipulateur de touches de mesure sur la plateforme de mesure s'effectue au moyen d'une dépression.
